# EUROPÄISCHE PATENTANMELDUNG

(11) **EP 1 365 133 A2**
(43) Veröffentlichungstag der Anmeldung: **26.11.2003**
(21) Anmeldenummer: 03101240.4
(22) Anmeldetag: 05.05.2003
(51) Int. Cl.: F02D 41/20

(54) **Messschaltung und Messwiderstandsanordnung**

(30) Priorität: 24.05.2002 DE 10223215
(71) Anmelder: SIEMENS AKTIENGESELLSCHAFT, 80333 München (DE)
(72) Erfinder: Chemisky, Eric, 67630, Lauterbourg (FR); Franz, Thomas, 90431, Nürnberg (DE); Schrod, Walter, 93057, Regensburg (DE)

(57) **Zusammenfassung**

Die Erfindung betrifft eine Messschaltung, insbesondere zur Messung der elektrischen Energie eines piezoelektrischen Aktors für eine Einspritzanlage, mit einem ersten Messwiderstand (1) mit einem ersten Spannungsabgriff und einem zweiten Spannungsabgriff sowie einem Messglied (3) mit einem Signaleingang und einem Referenzeingang, wobei der Signaleingang des Messglieds (3) mit dem ersten Spannungsabgriff des ersten Messwiderstands (1) verbunden ist. Es wird vorgeschlagen, dass der Referenzeingang des Messglieds (3) schwimmend mit dem zweiten Spannungsabgriff des ersten Messwiderstands (1) verbunden ist. Weiterhin betrifft die Erfindung ein Messwiderstandsanordnung, die für die erfindungsgemäße Messschaltung geeignet ist.

## Beschreibung

Die Erfindung betrifft eine Messschaltung, insbesondere zur Messung der elektrischen Energie eines piezoelektrischen Aktors einer Einspritzanlage, gemäß dem Oberbegriff des Anspruchs 1 sowie eine dafür geeignete Messwiderstandsanordnung gemäß dem Oberbegriff des Anspruchs 10.

Bei modernen Einspritzanlagen für Brennkraftmaschinen erfolgt die mechanische Ansteuerung der Einspritzventile durch piezoelektrische Aktoren, die im Vergleich zu herkömmlichen elektromagnetischen Aktoren ein besseres dynamisches Stellverhalten aufweisen.

Zur Minimierung der Schadstoffemissionen und des Kraftstoffverbrauchs müssen die Einspritzventile hierbei möglichst präzise die vorgegebenen Einspritzzeitpunkte und -dauern einhalten, was zu erheblichen Anforderungen an die elektrische Ansteuerung der Aktoren führt.

Hierbei wird die Erkenntnis ausgenutzt, dass die auf einen Aktor aufgebrachte elektrische Energie dessen Stellweg bestimmt. Es ist deshalb bekannt, die Aktorspannung in Abhängigkeit von der elektrischen Energie des Aktors zu regeln, um Stellfehler zu vermeiden. Hierzu wird während der Aufladung des Aktors laufend der Aktorstrom gemessen und aufintegriert, um die Aktorladung zu bestimmen. Aus der Aktorladung und der ebenfalls gemessenen Aktorspannung nach Beendigung des Ladevorgangs ergibt sich dann die Aktorenergie als Regelgröße.

Die Messung des Aktorstroms erfolgt hierbei mittels eines Messwiderstands (engl. Shunt), der von dem Aktorstrom durchflossen wird, so dass die über dem Aktor abfallende Spannung den Aktorstrom wiedergibt. Der Messwiderstand ist deshalb über ein Bandpassfilter mit einem Differenzverstärker verbunden, der die über dem Messwiderstand abfallende elektrische Spannung misst und für eine anschließende digitale Signalverarbeitung einem Analog/Digital-Wandler zuführt, wobei der Differenzverstärker und der Analog/Digital-Wandler einen gemeinsamen Masseanschluss aufweisen.

Nachteilig daran sind jedoch die relativ großen Kosten für den Differenzverstärker, da dieser hohen Anforderungen hinsichtlich Präzision, Bandbreite und Temperaturverträglichkeit genügen muss.

Der Erfindung liegt deshalb die Aufgabe zugrunde, eine Messschaltung zu schaffen, die bei möglichst geringen Kosten die Messung des Aktorstroms ermöglicht.

Darüber hinaus liegt der Erfindung die Aufgabe zugrunde, eine Messwiderstandsanordnung zu schaffen, die für die erfindungsgemäße Messschaltung geeignet ist.

Die Aufgabe wird hinsichtlich der Messschaltung durch die Merkmale des Anspruchs 1 und hinsichtlich der Messwiderstandsanordnung durch die Merkmale des Anspruchs 10 gelöst.

Die Erfindung umfasst die allgemeine technische Lehre, bei einem Messglied, wie beispielsweise dem eingangs beschriebenen Analog/Digital-Wandler, einen schwebenden Masseanschluss zu vorzusehen, der neben dem normalen Signaleingang als Referenzeingang verwendet wird, um eine differentielle Spannungsmessung zu ermöglichen.

Bei der erfindungsgemäßen Messschaltung ist also der Signalanschluss des Messglieds mit dem einen Spannungsabgriff des Messwiderstands verbunden, während der Masseanschluss des Messglieds mit dem anderen Spannungsabgriff des Messwiderstands verbunden ist. Das Massepotential des Messglieds schwimmt hierbei also entsprechend dem elektrischen Potentialniveau des Messwiderstands, so dass das Messglied stets die über dem Messwiderstand abfallende Spannung misst.

Der im Rahmen der Erfindung verwendete Begriff eines Messglieds ist allgemein zu verstehen und nicht auf den eingangs erwähnten Analog/Digital-Wandler beschränkt. Vielmehr kann es sich bei dem Messglied auch um ein Abtast-Halte-Glied oder einen Messwandler handeln.

Bei vielen Einspritzanlagen erfolgt die Ansteuerung der einzelnen Aktoren in zwei Gruppen, wobei für jede Gruppe jeweils ein Messwiderstand vorgesehen ist. Beispielsweise können bei einem 6-Zylinder-Motor jeweils drei Zylinder einer Zylinderbank zu einer Gruppe zusammengefasst werden, wobei die Aktorenergie für die Zylinder einer Gruppe jeweils über einen gemeinsamen Messwiderstand ermittelt wird.

In einer Variante der Erfindung weist die Messschaltung deshalb zwei Messwiderstände auf, die jeweils einer Gruppe von Brennräumen bzw. Aktoren zugeordnet sind, wobei die Spannungsmessung für die beiden Messwiderstände vorzugsweise durch ein einziges Messglied erfolgt.

Eine erfindungsgemäße Möglichkeit hierzu besteht darin, den Signaleingang und den Masseeingang des Messglieds über ein Schaltelement wahlweise mit den Spannungsabgriffen des einen Messwiderstands oder des anderen Messwiderstands zu verbinden. Das Messglied wird hierbei also mit dem Signaleingang und dem Masseeingang zweipolig auf einen der Messwiderstände geschaltet, wobei die Ansteuerung des Schaltelements vorzugsweise durch einen nachgeordneten Mikroprozessor erfolgt.

Eine andere erfindungsgemäße Möglichkeit zur Abfrage von zwei Messwiderständen mit einem einzigen Messglied besteht darin, die beiden Messwiderstände zu einem gemeinsamen Massekontakt zu verbinden, der fest mit dem Masseanschluss des Messglieds verbunden ist. Das Messglied wird hierbei also mit seinem Signaleingang einpolig mit dem Spannungsabgriff eines der beiden Messwiderstände verbunden.

Die Erfindung ist jedoch nicht auf die Abfrage von nur zwei Messwiderständen mit einem einzigen Messglied beschränkt. Bei größeren Brennkraftmaschinen mit einer entsprechend großen Zahl an Brennräumen können beispielsweise auch mehr als zwei Gruppen von Brennräumen gebildet werden, denen jeweils ein Messwiderstand zugeordnet ist. Hierbei kann die Verbindung des Messglieds mit den einzelnen Messwiderständen vorteilhaft durch eine Multiplexerschaltung erfolgen, die in der vorstehend beschriebenen Weise einpolig oder zweipolig ausgeführt sein kann.

In der bevorzugten Ausführungsform der Erfindung ist zwischen dem Messwiderstand und dem Messglied ein Filter angeordnet, wobei es sich vorzugsweise um ein Bandpassfilter oder ein Tiefpassfilter handelt, um die Bandbreite des Messsignals zu begrenzen. Dies ist vorteilhaft, um die erforderliche Abtastrate des Messglieds auf einen praktikablen Wert zu verringern. Das Filter weist hierbei vorzugsweise ebenfalls einen schwebenden Masseanschluss auf, der mit dem Masseanschluss des Messglieds verbunden ist.

Der schwebende Masseanschluss des Messglieds ermöglicht zwar eine differentielle Spannungsmessung ohne einen aufwändigen Differenzverstärker, jedoch weist das Ausgangssignal des Messglieds ebenfalls kein festes Referenzpotential auf. In der bevorzugten Ausführungsform der Erfindung ist das Messglied deshalb ausgangsseitig mit einem Pegelwandler verbunden, der aus dem potentialfrei schwebenden Messsignal ein Ausgangssignal mit einem festen Referenzpotential erzeugt. Beispielsweise kann hierfür ein Optokoppler, eine Transistorstufe oder ein kapazitiver Koppler eingesetzt werden. Die Pegelwandlung erfolgt hierbei jedoch vorzugsweise digital und hat deshalb keinen Einfluss auf die analoge Leistungsfähigkeit der Messschaltung.

Es ist jedoch unter Umständen auch möglich, die erfindungsgemäße Messschaltung ohne einen Pegelwandler am Ausgang des Messglieds zu betreiben, falls das masseseitige Potential an dem Messwiderstand hinreichend klein ist. In diesem Fall kann das Messglied beispielsweise über Schutzwiderstände mit einem nachgeordneten Mikroprozessor verbunden werden, wobei der unvermeidliche Masseversatz am Ausgang des Messglieds durch die Schaltschwellen der digitalen Schaltungen aufgefangen wird.

Darüber hinaus umfasst die Erfindung eine Messwiderstandsanordnung, die für die vorstehend beschriebene Variante der erfindungsgemäßen Messschaltung mit mehreren Messwiderständen geeignet ist, wobei die Messwiderstände einen gemeinsamen Masseanschluss aufweisen.

Die erfindungsgemäße Messwiderstandsanordnung weist deshalb zwei Messwiderstände auf, die auf einem Bauelementeträger angeordnet sind. Der erste Anschluss des ersten Messwiderstands kontaktiert hierbei eine erste Leiterbahn, während der zweite Anschluss des zweiten Messwiderstands mit einer zweiten Leiterbahn verbunden ist. Der erste Anschluss des zweiten Messwiderstands ist dagegen mit einer dritten Leiterbahn verbunden, während der zweite Anschluss des zweiten Messwiderstands gemeinsam mit dem zweiten Anschluss des ersten Messwiderstands mit der zweiten Leiterbahn verbunden ist, die somit einen gemeinsamen Masseanschluss bildet.

Die drei Leiterbahnen bilden hierbei vorzugsweise jeweils einen Spannungsabgriff, so dass die Spannungen über den beiden Messwiderständen getrennt abgegriffen werden können.

Darüber hinaus weisen die erste Leiterbahn und die dritte Leiterbahn vorzugsweise jeweils eine Stromzuführung auf, während die dritte Leiterbahn eine Stromabführung aufweist.

Die beiden Messwiderstände können auf dem Bauelementeträger beispielsweise nebeneinander oder hintereinander angeordnet werden, obwohl auch andere geometrische Anordnungen möglich sind.
Bei einer Anordnung der beiden Messwiderstände hintereinander sind die Spannungsabgriffe vorzugsweise gemeinsam auf der einen Seite angeordnet, während sich die Stromabführung vorzugsweise auf der anderen Seite befindet.

Falls die Messwiderstände dagegen nebeneinander angeordnet sind, so sind die Stromzuführungen vorzugsweise auf gegenüber liegenden Seiten des Bauelementeträgers angeordnet.

Andere vorteilhafte Weiterbildungen sind in den Unteransprüchen gekennzeichnet oder werden nachstehend zusammen mit der Beschreibung der bevorzugten Ausführungsbeispiele näher erläutert. Es zeigen:
- Figur 1: eine erfindungsgemäße Messschaltung mit einem einzigen Messwiderstand,
- Figur 2: eine erfindungsgemäße Messschaltung mit zwei Messwiderständen,
- Figur 3: ein weiteres Ausführungsbeispiel einer erfindungsgemäßen Messschaltung mit zwei Messwiderständen,
- Figur 4: eine Messwiderstandsanordnung mit zwei Messwiderständen sowie
- Figur 5: ein alternatives Ausführungsbeispiel einer erfindungsgemäßen Messwiderstandsanordnung.

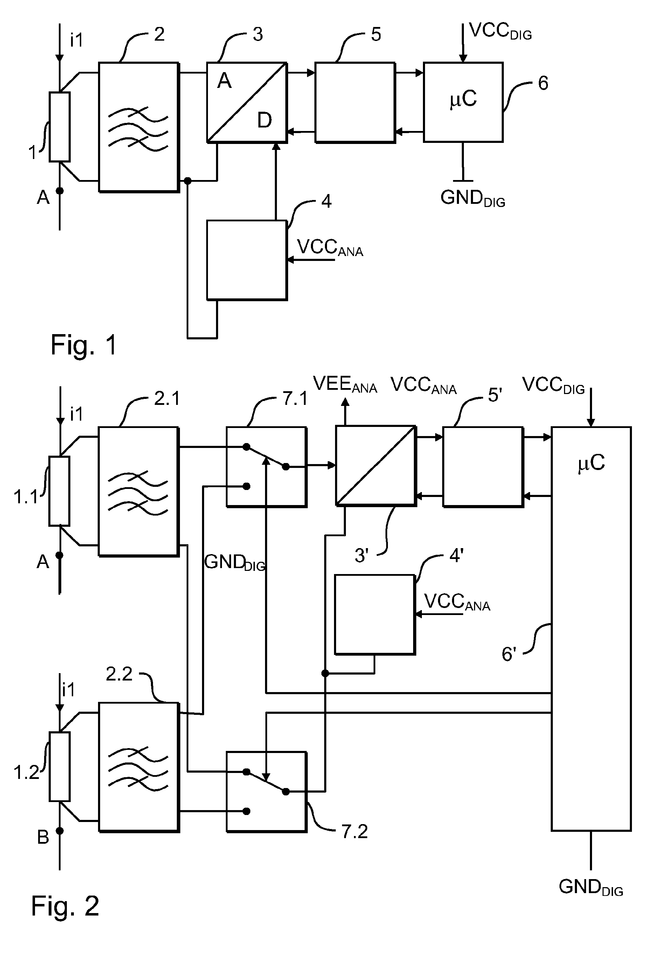

Die in Figur 1 in Form eines Blockschaltbilds dargestellte Messschaltung ermöglicht in einer Einspritzanlage die Messung eines Aktorstroms i1, um daraus die Aktorladung zu berechnen und die elektrische Ansteuerung des Aktors in Abhängigkeit von der elektrischen Energie des Aktors zu regeln, was in sich bekannt ist und deshalb nicht weiter beschrieben wird.

Hierzu weist die Messschaltung einen Messwiderstand 1 auf, der mit dem Aktor in Reihe geschaltet ist, so dass der Aktorstrom i1 durch den Messwiderstand 1 fließt und die über dem Messwiderstand 1 abfallende elektrische Spannung bestimmt.

Zur Messung der über dem Messwiderstand 1 abfallenden Spannung sind zwei Spannungsabgriffe vorgesehen, die mit einem Bandpassfilter 2 verbunden sind, wobei das Bandpassfilter 2 die Aufgabe hat, die Bandbreite des an dem Messwiderstand 1 abgegriffenen Messsignals zu begrenzen, um die für eine anschließende Signalabtastung erforderliche Abtastrate auf ein praktikables Maß zu senken.

Das Bandpassfilter 2 ist ausgangsseitig mit einem Analog/Digital-Wandler 3 verbunden, wobei der eine Ausgang des Bandpassfilters 2 mit dem Signaleingang des Analog/Digital-Wandlers 3 verbunden ist, während der andere Ausgang des Bandpassfilters 2 mit dem Masseanschluss des Analog/Digitalwandlers 3 verbunden ist. Das Massepotential des Analog/Digital-Wandlers 3 ist also nicht fest vorgegeben, sondern schwankt in Abhängigkeit von dem Potentialniveau an den beiden Spannungsabgriffen des Messwiderstands 1. Diese schwimmende Masse des Analog/Digital-Wandlers 3 hat zur Folge, dass der Analog/Digital-Wandler 3 ohne einen normalerweise erforderlichen Differenzverstärker eine differentielle Spannungsmessung an dem Messwiderstand 1 ermöglicht. Der Analog/Digital-Wandler 3 misst also die über dem Messwiderstand 1 abfallende elektrische Spannung und gibt ausgangsseitig ein entsprechendes Digitalsignal ab.

Darüber hinaus weist die Messschaltung eine Referenzspannungsquelle 4 auf, die dem Analog/Digital-Wandler 3 eine Referenzspannung bereitstellt, wobei die Spannungsversorgung der Referenzspannungsquelle durch eine Versorgungsspannung VCC_{ANA} erfolgt. Der Masseanschluss der Referenzspannungsquelle 4 ist ebenfalls mit dem Masseanschluss des Analog/Digital-Wandlers 3 verbunden, so dass auch das Massepotential der Referenzspannungsquelle 4 nicht festgelegt ist, sondern in Abhängigkeit von dem Potentialniveau des Messwiderstands 1 schwankt.

Das schwimmende Massepotential des Analog/Digital-Wandlers 3 ermöglicht zwar ohne einen aufwändigen Differenzverstärker eine differentielle Spannungsmessung an dem Messwiderstand 1, jedoch tritt hierbei an dem Ausgang des Analog/Digital-Wandlers 3 ein entsprechender Masseversatz auf, wenn das Potentialniveau des Messwiderstands 1 schwankt. Der Analog/Digital-Wandler 3 ist deshalb ausgangsseitig mit einem Pegelwandler 5 in Form eines Optokopplers verbunden, der ein digitales Ausgangssignal mit festgelegten Spannungspegeln erzeugt.

Die Auswertung des Messsignals erfolgt dann durch einen Mikroprozessor 6, der mit dem Pegelwandler 5 verbunden ist.

Das in Figur 2 dargestellte Ausführungsbeispiel einer erfindungsgemäßen Messschaltung dient zur Messung des elektrischen Stroms durch zwei Messwiderstände 1.1, 1.2, wobei die beiden Messwiderstände 1.1, 1.2 jeweils einer Gruppe von Brennräumen zugeordnet sind.

Ausgangsseitig sind die beiden Messwiderstände 1.1, 1.2 mit jeweils einem Bandpassfilter 2.1, 2.2 verbunden, die die Bandbreite des an den Messwiderständen 1.1, 1.2 abgegriffenen Messsignals reduzieren, um mit einer praktikablen Abtastrate eine Signalabtastung zu ermöglichen.

Weiterhin weist die Messschaltung zwei Multiplexer 7.1, 7.2 auf, die einen Analog/Digital-Wandler 3' wahlweise mit dem einen Bandpassfilter 2.1 oder mit dem anderen Bandpassfilter 2.2 verbinden.

Der Multiplexer 7.1 weist hierzu zwei Signaleingänge auf, die mit jeweils einem Ausgang der beiden Bandpassfilter 2.1, 2.2 verbunden sind, während der Signalausgang des Multiplexers 7.1 mit dem Signaleingang des Analog/Digital-Wandlers 3' verbunden ist. Der Multiplexer 7.1 schaltet also den Signaleingang des Analog/Digital-Wandlers 3' wahlweise auf einen der beiden Bandpassfilter 2.1, 2.2.

Der andere Multiplexer 7.2 weist ebenfalls zwei Signaleingänge auf, die jeweils mit dem anderen Ausgang der beiden Bandpassfilter 2.1, 2.2 verbunden sind, während der Signalausgang des Multiplexers 7.2 mit dem Masseanschluss des Analog/Digital-Wandlers 3' verbunden ist. Der Multiplexer 7.2 schaltet also den Masseanschluss des Analog/Digital-Wandlers 3' wahlweise auf einen der beiden Bandpassfilter 2.1, 2.2, so dass das Massepotential des Analog/Digital-Wandlers 3' nicht festgelegt ist, sondern durch das Potentialniveau eines der beiden Messwiderstände 1.1, 1.2 bestimmt wird.

Darüber hinaus weist die Messschaltung eine Referenzspannungsquelle 4' auf, die dem Analog/Digital-Wandler 3 eine Referenzspannung bereitstellt, wobei die Spannungsversorgung der Referenzspannungsquelle 4' durch eine Versorgungsspannung VCC_{ANA} erfolgt. Der Masseanschluss der Referenzspannungsquelle 4' ist ebenfalls mit dem Masseanschluss des Analog/Digital-Wandlers 3' verbunden, so dass auch das Massepotential der Referenzspannungsquelle 4' nicht festgelegt ist, sondern in Abhängigkeit von dem Potentialniveau des Messwiderstands 1.1 bzw. 1.2 schwankt.

Ausgangsseitig ist der Analog/Digital-Wandler 3' wiederum mit einem Pegelwandler 5' verbunden, der ein Ausgangssignal mit vorgegebenen elektrischen Spannungspegeln erzeugt.

Die Auswertung dieses Ausgangssignals erfolgt ebenfalls durch einen Mikroprozessor 6', wobei der Mikroprozessor 6' auch die beiden Multiplexer 7.1, 7.2 ansteuert und damit festlegt, welcher der beiden Messwiderstände 1.1, 1.2 abgefragt wird.

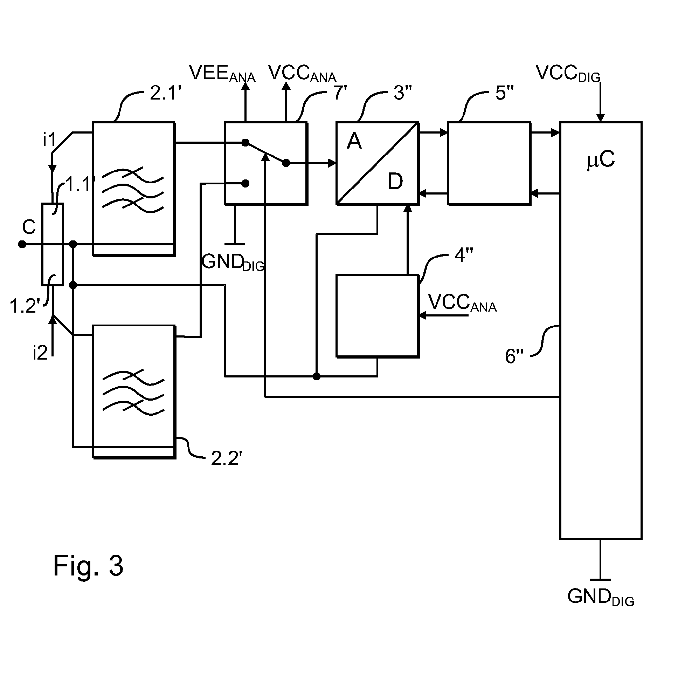

Das in Figur 3 dargestellte Ausführungsbeispiel einer erfindungsgemäße Messschaltung stimmt weitgehend mit dem vorstehend beschriebenen und in Figur 2 dargestellten Ausführungsbeispiel überein, so dass zur Ergänzung auch auf die vorstehende Beschreibung verwiesen wird.

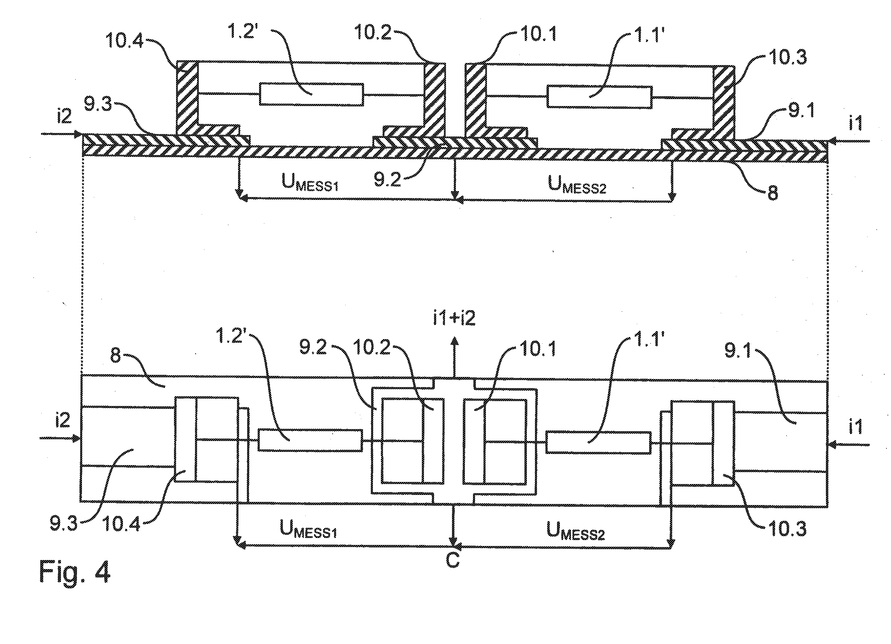

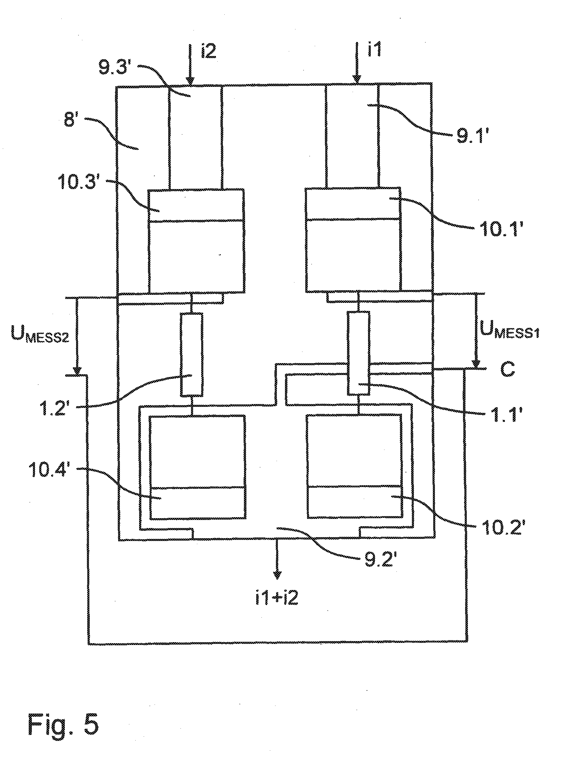

In diesem Ausführungsbeispiel weist die Messschaltung ebenfalls zwei Messwiderstände 1.1', 1.2' auf, wobei die beiden Messwiderstände 1.1', 1.2' einen gemeinsamen Massepunkt C aufweisen, so dass man auf einen der beiden Multiplexer 7.1, 7.2 verzichten kann. Die beiden Messwiderstände 1.1', 1.2' sind hierbei entsprechend einer der beiden Messwiderstandsanordnungen konfiguriert, die in den Figuren 4 und 5 dargestellt sind. Die aus den beiden Messwiderständen 1.1', 1.2' bestehende Messwiderstandsanordnung weist also drei Spannungsabgriffe auf, wobei der mittlere Spannungsabgriff als gemeinsamer Masseanschluss sowie als Stromabführung dient. Die beiden äußeren Spannungsabgriffe dienen dagegen zur Messung der über den beiden Messwiderständen 1.1', 1.2' abfallenden Spannung und zur Stromzuführung.

Ausgangsseitig sind die beiden Messwiderstände 1.1', 1.2' mit jeweils einem Bandpassfilter 2.1', 2.2' verbunden, das die Bandbreite des an den Messwiderständen 2.1', 2.2' abgegriffenen Messsignals verringert, um eine Signalabtastung mit einer praktikablen Abtastrate zu ermöglichen.

Einer der beiden Signalausgänge der beiden Bandpassfilter 2.1', 2.2' ist jeweils mit einem der beiden Signaleingänge eines Multiplexers 7' verbunden, so dass der Multiplexer 7' einen der beiden Bandpassfilter 2.1', 2.2' einpolig auf einen nachgeordneten Analog/Digital-Wandler 3'' durchschaltet.

Der Masseanschluss des Analog/Digital-Wandlers 3" ist hierbei mit dem gemeinsamen Massepunkt C der beiden Messwiderständen 2.1', 2.2' verbunden, so dass das Massepotential des Analog/Digital-Wandlers 3" nicht fest vorgegebenen ist, sondern in Abhängigkeit von dem elektrischen Potential des gemeinsamen Massepunkts C schwanken kann. Dies ermöglicht ohne einen aufwändigen Differenzverstärker eine differentielle Spannungsmessung an den beiden Messwiderständen 2.1', 2.2'.

Darüber hinaus weist die Messschaltung auch in diesem Ausführungsbeispiel eine Referenzspannungsquelle 4" auf, die dem Analog/Digital-Wandler 3" eine Referenzspannung bereitstellt, wobei die Spannungsversorgung der Referenzspannungsquelle 4' ' durch eine Versorgungsspannung VCC_{ANA} erfolgt. Der Masseanschluss der Referenzspannungsquelle 4" ist ebenfalls mit dem Masseanschluss des Analog/Digital-Wandlers 3" verbunden, so dass auch das Massepotential der Referenzspannungsquelle 4" nicht festgelegt ist, sondern in Abhängigkeit von dem Potentialniveau des gemeinsamen Massepunkts C schwankt.

Ausgangsseitig ist der Analog/Digital-Wandler 3" wiederum mit einem Pegelwandler 5" verbunden, der ein Ausgangssignal mit vorgegebenen elektrischen Spannungspegeln erzeugt.

Die Auswertung dieses Ausgangssignals erfolgt ebenfalls durch einen Mikroprozessor 6", wobei der Mikroprozessor 6" auch den Multiplexer 7' ansteuert und damit festlegt, welcher der beiden Messwiderstände 2.1', 2.2' abgefragt wird.

Figur 4 zeigt eine Detailansicht der in Figur 3 dargestellten Messwiderstandsanordnung der beiden Messwiderstände 1.1', 1.2', wobei die obere Darstellung eine Querschnittsansicht zeigt, während die untere Darstellung eine Aufsicht wiedergibt.

Zur mechanischen Fixierung der beiden Messwiderstände 1.1', 1.2' weist die dargestellte Messwiderstandsanordnung eine Leiterplatte 8 auf, die an ihrer Oberseite mehrere Leiterbahnen 9.1-9.3 trägt, die elektrisch gegeneinander isoliert sind.

Die mittlere Leiterbahn 9.2 bildet hierbei den gemeinsamen Massepunkt C der in Figur 3 dargestellten Messschaltung, so dass auf der Leiterbahn 9.2 zwei Kontaktelemente 10.1, 10.2 angebracht sind, die jeweils einen Anschluss der beiden Messwiderstände 1.1', 1.2' kontaktieren.

Auf den äußeren Leiterbahnen 9.1, 9.3 ist jeweils ein weiteres Kontaktelement 10.3, 10.4 angebracht, wobei die beiden Kontaktelemente 10.3, 10.4 die jeweils anderen Anschlüsse der beiden Messwiderstände 1.1', 1.2' kontaktieren.

Die Leiterbahnen 9.1-9.3 sind jeweils seitlich an die Kante der Leiterplatte 8 herausgeführt und bilden dort auf der einen Seite Spannungsabgriffe, wie aus der Aufsichtsdarstellung aus Figur 4 unten ersichtlich ist.

Die mittlere Leiterbahn 9.2 ist beidseitig an den Rand der Leiterplatte 8 herausgeführt, wodurch auf der anderen Seitenkante der Leiterplatte 8 eine Stromabführung gebildet wird.

Figur 5 zeigt ein weiteres Ausführungsbeispiel einer erfindungsgemäßen Widerstandsanordnung, das in der in Figur 3 gezeigten Messschaltung eingesetzt werden kann.

Dieses Ausführungsbeispiel stimmt weitgehend mit dem vorstehend beschriebenen und in Figur 4 dargestellten Ausführungsbeispiel einer erfindungsgemäßen Messwiderstandsanordnung überein, so dass im folgenden zur Ergänzung auch auf die vorstehende Beschreibung verwiesen wird.

Diese Messwiderstandsanordnung weist ebenfalls eine Leiterplatte 8' auf, die an ihrer Oberseite mehrere Leiterbahnen 9.1'-9.3' trägt. Die Leiterbahn 9.1' dient hierbei als Stromzuführung für den Aktorstrom i1, während die Leiterbahn 9.3' als Stromzuführung für den Aktorstrom i2 dient. Die Leiterbahn 9.2' bildet dagegen den gemeinsamen Massepunkt C der beiden Messwiderstände 1.1' und 1.2'.

Die Kontaktierung der Messwiderstände 1.1', 1.2' erfolgt durch vier Kontaktelemente 10.1'-10.4', die auf den Leiterbahnen 9.1'-9.3' angebracht sind.

Das Kontaktelement 10.1' ist hierbei auf der Leiterbahn 9.1' angebracht, während das Kontaktelement 10.2' auf der mittigen Leiterbahn 9.2' angebracht ist. Zusammen kontaktieren die beiden Kontaktelement 10.1' und 10.2' den Messwiderstand 1.1' .

Das Kontaktelement 10.3' ist dagegen auf der Leiterbahn 9.3' angebracht, während das Kontaktelement 10.4' ebenfalls auf der Leiterbahn 9.2' angebracht ist, so dass die beiden Kontaktelemente 10.3' und 10.4' den Messwiderstand 1.2' kontaktieren.

Eine Besonderheit dieses Ausführungsbeispiels besteht darin, dass die beiden Messwiderstände 1.1', 1.2' sowie die beiden Leiterbahnen 9.1', 9.2' für die Stromzuführung nebeneinander angeordnet sind. Die Stromzuführung erfolgt hierbei also aus derselben Richtung, wohingegen die Stromzuführung bei dem Ausführungsbeispiel gemäß Figur 4 aus entgegengesetzten Richtungen erfolgt.

Die Leiterbahnen 9.1', 9.3' der Stromzuführung sind hierbei an gegenüber liegenden Seiten der Leiterplatte 8' an die Seitenkante herausgeführt und bilden dort jeweils einen Spannungsabgriff, so dass die Spannungsabgriffe auf gegenüberliegenden Seite der Leiterplatte liegen, wohingegen die Spannungsabgriffe bei dem Ausführungsbeispiel gemäß Figur 4 auf derselben Seite der Leiterplatte liegen.

Schließlich ist die Leiterbahn 9.2' seitlich zu einer Seitenkante der Leiterplatte 8 herausgeführt und bildet dort den gemeinsamen Masseanschluss C der beiden Messwiderstände.

Die Erfindung ist nicht auf die vorstehend beschriebenen bevorzugten Ausführungsbeispiele beschränkt. Vielmehr ist eine Vielzahl von Varianten und Abwandlungen denkbar, die ebenfalls von dem Erfindungsgedanken Gebrauch machen und deshalb in den Schutzbereich fallen.

## Patentansprüche

1. Messschaltung, insbesondere zur Messung der elektrischen Energie eines piezoelektrischen Aktors für eine Einspritzanlage, mit
einem ersten Messwiderstand (1, 1.1, 1.1') mit einem ersten Spannungsabgriff und einem zweiten Spannungsabgriff sowie
einem Messglied (3, 3', 3") mit einem Signaleingang und einem Referenzeingang, wobei der Signaleingang des Messglieds (3, 3', 3") mit dem ersten Spannungsabgriff des ersten Messwiderstands (1, 1.1, 1.1') verbunden ist,
**dadurch gekennzeichnet,**
**dass** der Referenzeingang des Messglieds (3, 3', 3") schwimmend mit dem zweiten Spannungsabgriff des ersten Messwiderstands (1, 1.1', 1.2') verbunden ist.

2. Messschaltung nach Anspruch 1,
**gekennzeichnet durch**
einen zweiten Messwiderstand (1.2, 1.2') mit einem ersten Spannungsabgriff und einem zweiten Spannungsabgriff,
wobei der Signaleingang des Messglieds (3, 3', 3") **durch** ein erstes Schaltelement (7.1, 7') wahlweise mit dem ersten Spannungsabgriff des ersten Messwiderstands (1.1, 1.1') oder mit dem ersten Spannungsabgriff des zweiten Messwiderstands (1.2, 1.2') verbindbar ist.

3. Messschaltung nach Anspruch 2,
**dadurch gekennzeichnet,**
**dass** der zweite Spannungsabgriff des ersten Messwiderstands (1.1') mit dem zweiten Spannungsabgriff des zweiten Messwiderstands (1.2') und mit dem Referenzeingang des Messglieds (3") verbunden ist.

4. Messschaltung nach Anspruch 2,
**dadurch gekennzeichnet,**
**dass** der Referenzeingang des Messglieds (3') über ein zweites Schaltelement (7.2) wahlweise mit dem zweiten Spannungsabgriff des ersten Messwiderstands (1.1) oder mit dem zweiten Spannungsabgriff des zweiten Messwiderstands (1.2) verbindbar ist.

5. Messschaltung nach mindestens einem der vorhergehenden Ansprüche,
**dadurch gekennzeichnet,**
**dass** zwischen dem ersten Messwiderstand (1, 1.1, 1.1') und/oder dem zweiten Messwiderstand (1.2) einerseits und dem Messglied (3, 3', 3") andererseits ein Filter (2, 2.1, 2.2 2.1', 2.2") angeordnet ist, wobei das Filter einen Masseanschluss aufweist, der schwimmend mit dem zweiten Spannungsabgriff des ersten oder zweiten Messwiderstands (1, 1.1, 1.2, 1.1', 1.2') und dem Referenzeingang des Messglieds (3, 3', 3") verbunden ist.

6. Messschaltung nach mindestens einem der vorhergehenden Ansprüche,
**dadurch gekennzeichnet,**
**dass** das Messglied (3, 3', 3") einen Analog-Digital-Wandler aufweist.

7. Messschaltung nach mindestens einem der vorhergehenden Ansprüche,
**dadurch gekennzeichnet,**
**dass** dem Messglied (3, 3', 3") ein Pegelwandler (5, 5', 5") nachgeschaltet ist.

8. Messschaltung nach Anspruch 7,
**dadurch gekennzeichnet,**
**dass** der Pegelwandler (5, 5', 5") einen Optokoppler oder eine Transistorstufe oder einen kapazitiven Koppler aufweist.

9. Messschaltung nach mindestens einem der vorhergehenden Ansprüche,
**dadurch gekennzeichnet,**
**dass** das Messglied (3, 3', 3") ausgangsseitig mit einem Mikroprozessor (6, 6', 6") verbunden ist.

10. Messwiderstandsanordnung, insbesondere für eine Messschaltung nach einem der vorhergehenden Ansprüche, mit
einem ersten Messwiderstand (1.1') mit einem ersten Anschluss und einem zweiten Anschluss sowie
einem Bauelementeträger (8, 8') mit mehreren elektrisch gegeneinander isolierten Leiterbahnen (9.1-9.3, 9.1'-9.3'),
wobei der erste Anschluss des ersten Messwiderstands (1.1') elektrisch mit einer ersten Leiterbahn (9.1, 9.1') verbunden ist,
während der zweite Anschluss des ersten Messwiderstands (1.1') elektrisch mit einer zweiten Leiterbahn (9.2, 9.2') verbunden ist,
**gekennzeichnet durch**
einen zweiten Messwiderstand (1.2') mit einem ersten Anschluss und einem zweiten Anschluss,
wobei der erste Anschluss des zweiten Messwiderstands (1.2') elektrisch mit einer dritten Leiterbahn (9.3, 9.3') verbunden ist,
während der zweite Anschluss des zweiten Messwiderstands (1.2') gemeinsam mit dem zweiten Anschluss des ersten Messwiderstands (1.1') elektrisch mit der zweiten Leiterbahn (9.2, 9.2') verbunden ist.

11. Messwiderstandsanordnung nach Anspruch 10,
**dadurch gekennzeichnet,**
**dass** die erste Leiterbahn (9.1, 9.1') und die zweite Leiterbahn (9.2, 9.2') und die dritte Leiterbahn (9.3, 9.3') jeweils einen Spannungsabgriff aufweisen.

12. Messwiderstandsanordnung nach Anspruch 10 und/oder Anspruch 11,
**dadurch gekennzeichnet,**
**dass** die erste Leiterbahn (9.1, 9.1') und die dritte Leiterbahn (9.3, 9.3') jeweils eine Stromzuführung aufweisen, während die zweite Leiterbahn (9.2, 9.2') eine Stromabführung aufweist.

13. Messwiderstandsanordnung nach mindestens einem der Ansprüche 10 bis 12,
**dadurch gekennzeichnet,**
**dass** die beiden Messwiderstände (1.1', 1.2') bezüglich ihrer Längsachse hintereinander auf dem Bauelementeträger (8) angeordnet sind, wobei die zweite Leiterbahn (9.2) zwischen den beiden Messwiderständen (1.1', 1.2') angeordnet ist.

14. Messwiderstandsanordnung nach Anspruch 13,
**dadurch gekennzeichnet,**
**dass** die Spannungsabgriffe gemeinsam auf einer Seite des Bauelementeträgers (8) angeordnet sind.

15. Messwiderstandsanordnung nach Anspruch 14,
**dadurch gekennzeichnet,**
**dass** die Spannungsabgriffe einerseits und die Stromabführung andererseits auf gegenüber liegenden Seiten des Bauelementeträgers (8) angeordnet sind.

16. Messwiderstandsanordnung nach mindestens einem der Ansprüche 10 bis 12,
**dadurch gekennzeichnet,**
**dass** die beiden Messwiderstände (1.1', 1.2') bezüglich ihrer Längsachse nebeneinander auf dem Bauelementeträger (8) angeordnet sind.

17. Messwiderstandsanordnung nach Anspruch 16,
**dadurch gekennzeichnet,**
**dass** die erste Leiterbahn (9.1') neben der dritten Leiterbahn (9.3') angeordnet ist.

18. Messwiderstandsanordnung nach mindestens einem der Ansprüche 16 bis 17,
**dadurch gekennzeichnet,**
**dass** die Stromzuführungen einerseits und die Stromabführung andererseits auf gegenüber liegenden Seiten des Bauelementeträgers (8) angeordnet sind.
